# EUROPÄISCHE PATENTANMELDUNG

(11) **EP 3 534 171 A1**
(43) Veröffentlichungstag der Anmeldung: **04.09.2019**
(21) Anmeldenummer: 18159209.8
(22) Anmeldetag: 28.02.2018
(51) Int. Cl.: G01R 33/565, G01R 33/58

(54) **KORREKTUR VON GEOMETRISCHEN VERZERRUNGEN IN EINEM MR-BILD**

(71) Anmelder: Siemens Healthcare GmbH, 91052 Erlangen (DE)
(72) Erfinder: Zeller, Mario, 91054 Erlangen (DE)

(57) **Zusammenfassung**

Die Erfindung betrifft eine Korrektur von geometrischen Verzerrungen in einem MR-Bild. Es werden MR-Daten eines Volumenabschnitts einer Untersuchungsperson (13) mittels einer Magnetresonanzanlage (10) erfasst. In dem Volumenabschnitt befinden sich mehrere Bezugsmarkierungen (1), welche in vorbestimmten Soll-Abständen zueinander angeordnet sind. Abhängig von den erfassten MR-Daten wird das MR-Bild rekonstruiert. Eine jeweilige Bild-Position (2) für jede der Bezugsmarkierungen (1) innerhalb des MR-Bildes wird bestimmt. Abstände zwischen den Bild-Positionen (2) werden bestimmt und jeweils mit einem entsprechenden der Soll-Abstände verglichen. Abhängig von den Ergebnissen dieses Vergleichs wird das MR-Bild korrigiert.

## Beschreibung

Die vorliegende Erfindung betrifft die Korrektur von geometrischen Verzerrungen bei MR-Bildern, welche von einer Magnetresonanzanlage erzeugt werden.

Zur Planung einer Radiotherapie oder einer Biopsie kommt die MR-Bildgebung immer häufiger zum Einsatz. Ein dabei auftretendes Problem sind geometrische Verzerrungen der MR-Bilder, welche durch verschiedene Effekte verursacht werden. Ein Großteil dieser Verzerrungen geht auf Abweichungen des Hauptmagnet- oder Gradientenfeldes von den idealen Bedingungen (konstant bzw. linear abhängig vom Ort) zurück und wird von bekannten Algorithmen zur zweidimensionalen oder dreidimensionalen Verzerrungskorrektur weitestgehend korrigiert.

Es ist allerdings bekannt, dass die Geometrietreue einer Magnetresonanzanlage über eine längere Zeitspanne im Millimeterbereich variieren kann. Vermutete Ursachen für diese Variationen, welche für die konventionelle Bildgebung vernachlässigbar sind, sind äußere Einflüsse auf das B0-Feld, thermische Schwankungen, Fertigungstoleranzen oder auch patientenspezifische Justagen. Bei der Radiotherapieplanung sind allerdings Genauigkeiten im Submillimeterbereich erforderlich. Auch bei der intrakraniellen stereotaktischen Radiochirurgie mittels Gamma Knife, bei welcher mehrere Strahlungsquellen auf ein winziges Gehirnareal fokussiert werden müssen, sind die oben erwähnten Variationen im Millimeterbereich bereits problematisch.

Daher stellt sich die vorliegende Erfindung die Aufgabe, geometrische Verzerrungen in MR-Bildern, welche insbesondere auf die mangelnde Geometrietreue der Magnetresonanzanlage zurückzuführen sind, zu korrigieren.

Erfindungsgemäß wird diese Aufgabe durch ein Verfahren zur Korrektur von geometrischen Verzerrungen in einem MR-Bild nach Anspruch 1, durch eine Magnetresonanzanlage nach Anspruch 8, durch ein Computerprogrammprodukt nach Anspruch 10 oder durch einen elektronisch lesbaren Datenträger nach Anspruch 11 gelöst. Die abhängigen Ansprüche definieren bevorzugte und vorteilhafte Ausführungsformen der vorliegenden Erfindung.

Im Rahmen der vorliegenden Erfindung wird ein Verfahren zur Korrektur von geometrischen Verzerrungen in einem MR-Bild bereitgestellt. Das erfindungsgemäße Verfahren umfasst dabei folgende Schritte:
- Erfassen von MR-Daten eines Volumenabschnitts einer lebenden Untersuchungsperson oder eines Patienten mit Hilfe einer Magnetresonanzanlage. Dabei befinden sich innerhalb des Volumenabschnitts mehrere Bezugsmarkierungen, welche vorbestimmte Soll-Abstände zueinander aufweisen. Das heißt, die Lage oder Position dieser Bezugsmarkierungen ("fiduacial markers") zueinander ist zu jedem Zeitpunkt bekannt, da die Anordnung dieser Bezugsmarkierungen insbesondere (bezüglich der Magnetresonanzanlage) fest oder unveränderlich ist. Da die Lage oder Position der Bezugsmarkierungen relativ zueinander konstant ist, sind auch die Abstände der Bezugsmarkierungen bekannt und konstant. Diese feststehenden Abstände zwischen den Bezugsmarkierungen werden im Folgenden auch als Soll-Abstände bezeichnet.
- Rekonstruieren des MR-Bildes abhängig von den vorab erfassten MR-Daten. In diesem Schritt wird anhand der MR-Daten das MR-Bild der Untersuchungsperson oder des Patienten rekonstruiert. Anhand dieses MR-Bildes kann dann eine Planung einer Radiotherapie oder Biopsie für den Patienten erfolgen. Es handelt sich also insbesondere nicht um ein MR-Bild, welches zur Kalibrierung der Magnetresonanzanlage erzeugt wird.
- Bestimmen einer jeweiligen Bild-Position für jede der Bezugsmarkierungen innerhalb des rekonstruierten MR-Bildes. In diesem Schritt wird die Position jeder Bezugsmarkierung innerhalb des MR-Bildes bestimmt, wobei diese Position als Bild-Position bezeichnet wird. Nach diesem Schritt ist demnach für jede der Bezugsmarkierungen bekannt, an welcher Stelle oder Position (nämlich der zugehörigen Bild-Position) sich die jeweilige Bezugsmarkierung innerhalb des MR-Bildes befindet.
- Bestimmen von Abständen zwischen den Bild-Positionen. In diesem Schritt werden durch eine entsprechende Auswertung des rekonstruierten MR-Bildes Ist-Abstände zwischen den Bild-Positionen für die Bezugsmarkierungen ermittelt.
- Vergleichen der Ist-Abstände jeweils mit zugehörigen Soll-Abständen. Da die Bild-Position für jede Bezugsmarkierung im MR-Bild aus dem entsprechenden Schritt des erfindungsgemäßen Verfahrens bekannt ist, kann auch für jeden Soll-Abstand der entsprechende Ist-Abstand bestimmt werden. Während der Soll-Abstand den Abstand zwischen zwei Bildmarkierungen definiert, gibt der diesem Soll-Abstand entsprechende Ist-Abstand den Abstand zwischen den beiden Bild-Positionen an, welche jeweils der Position der Abbildungen der beiden Bildmarkierungen in dem MR-Bild entsprechen.
- Korrigieren des MR-Bildes in Abhängigkeit von den Ergebnissen des Vergleichs-Schritts, d.h. des Vergleichens der Ist-Abstände mit den Soll-Abständen. In diesem Schritt erfolgt die Korrektur der geometrischen Verzerrungen in dem MR-Bild anhand des Unterschieds zwischen den Soll-Abständen und den zugehörigen Ist-Abständen.

Da der räumliche Abstand bzw. Soll-Abstand der Bezugsmarkierungen zueinander exakt bekannt ist und da die Bezugsmarkierungen in jedem MR-Bild vorhanden sind, können anhand des entsprechenden Ist-Abstands bzw. Abstands der Bild-Positionen in dem jeweiligen MR-Bild im Vergleich zu den zugehörigen Soll-Abständen die geometrischen Verzerrungen sehr genau bestimmt und somit eliminiert bzw. korrigiert werden.

Insbesondere kann abhängig von dem Ergebnis des Vergleichs der Ist-Abstände mit den zugehörigen Soll-Abständen ein Deformationsfeld bestimmt werden, mit welchem dann das MR-Bild korrigiert werden kann. Dabei beschreibt das Deformationsfeld quasi das Ergebnis einer nichtlinearen räumlichen Registrierung. Das Deformationsfeld entspricht einem (zweidimensionalen oder dreidimensionalen) Vektorfeld, welches jedem Punkt eines Referenzdatensatzes eine Verschiebung (oder einen Deformationsvektor) zuordnet, welche zu seinem korrespondierenden Punkt in dem anzupassenden Datensatz oder MR-Bild weist. Der Deformationsvektor gibt also die Koordinatendifferenz zwischen einem Punkt im Referenzdatensatz und dem entsprechenden Punkt im jeweiligen Volumenabschnitt an. Mit Hilfe des Deformationsfeldes kann jeder Bildpunkt des rekonstruierten MR-Bildes derart verschoben werden, dass dadurch die geometrischen Verzerrungen korrigiert werden.

Die Bezugsmarkierungen sind insbesondere in einem Rahmen (z.B. einem stereotaktischen Rahmen oder Stereotaxierahmen) integriert, mit welchem ein Teil (z.B. der Kopf) der Untersuchungsperson fixiert wird. Der Volumenabschnitt, von dem erfindungsgemäß MR-Daten erfasst werden, umfasst zumindest einen Abschnitt dieses Teils. Beispiele für einen stereotaktischen Rahmen sind ein Leksell-Rahmen oder ein Brown-Roberts-Wells-Rahmen. Die Bezugsmarkierungen sind insbesondere genau vermessen.

Da der Rahmen an dem Teil fixiert ist, verändert sich die Lage der Bezugsmarkierungen nicht zur Lage des Teils der Untersuchungsperson.

Mit dem starren und insbesondere rechteckigen Rahmen wird beispielsweise der Kopf des Patienten bezüglich einer chirurgischen oder strahlentherapeutischen Behandlung fixiert. Da der Rahmen an dem Patienten fixiert ist und da die Bezugsmarkierungen in dem Rahmen integriert sind, ist somit auch die Position der jeweiligen Bildmarkierung bezüglich der Patientenanatomie fixiert oder konstant.

Die Bezugsmarkierungen sind insbesondere aus einem Material, welches eine sehr hohe Signalintensität bei der MR-Anregung erzeugt. Darüber hinaus ist es vorteilhaft, wenn jede Bezugsmarkierung eine spezielle Form aufweist, welche die bildbasierte Detektion der Bezugsmarkierungen unterstützt.

Die Bezugsmarkierungen umfassen vorteilhafterweise mit CuSO₄ dotiertes Wasser, um dadurch ein eindeutiges Signal in dem zugehörigen rekonstruierten MR-Bild zu liefern.

Beispielsweise können die Bezugsmarkierungen jeweils aus N-förmigen Markierungskanälen gebildet sein, welche mit einer Kupfersulfatlösung gefüllt sind.

Indem die Bezugsmarkierungen aus einem Material, wie z.B. Cu-SO₄ dotiertes Wasser, bestehen, welches ein eindeutiges Signal in dem rekonstruierten MR-Bild erzeugt, kann die Bild-Position der jeweiligen Bezugsmarkierung sehr einfach in dem rekonstruierten MR-Bild ermittelt werden.

Die Bezugsmarkierungen können beispielsweise aufgrund ihrer recht genauen bekannten räumlichen Position und dem eindeutigen Signal mit Hilfe einer Segmentierung, einer Mustererkennung oder mittels neuronaler Netze ("deep learning") in dem rekonstruierten MR-Bild erkannt und dadurch die zugehörige Bild-Position ermittelt werden.

Der Einsatz einer Segmentierung, einer Mustererkennung oder von neuronalen Netzen ermöglicht vorteilhafterweise ein sehr genaues Bestimmen der Bild-Positionen der zugehörigen Bezugsmarkierungen in dem rekonstruierten MR-Bild.

Das Bestimmen der Bild-Positionen kann folgende UnterSchritte umfassen:
- Erstellen eines ersten (synthetischen) Bildes, in welchem im Wesentlichen nur die Bezugsmarkierungen dargestellt sind. Dieses erste Bild kann beispielsweise nur eine Abbildung des Rahmens (ohne Patienten) darstellen, welches auf Basis der bekannten Soll-Abstände der Bezugsmarkierungen generiert wurde. Zur Erstellung dieses ersten Bildes existieren folgende Möglichkeiten:
   ∘ Das erste Bild kann künstlich mit einem Bilderstellungsprogramm erzeugt werden.
   ∘ Es wird ein MR-Bild des Rahmens erzeugt, welches dann auf einem CT-Bild (d.h. mit einem Computertomograph erstellten Bild) des Rahmens registriert wird, wodurch sich als Ergebnis das erste Bild ergibt.
   ∘ Das erste Bild entspricht einem geometrietreuen CT-Bild oder CT-Aufnahme des Rahmens.
- Extrahieren oder Herausschneiden einer Anatomie aus dem rekonstruierten MR-Bild, um ein zweites MR-Bild zu erstellen. In diesem Schritt werden aus dem MR-Bild, welches anhand der von dem Volumenabschnitt erfassten MR-Daten rekonstruiert wurde, die den Patienten darstellenden Bereiche entfernt, um das zweite MR-Bild zu erhalten.
- Registrieren des ersten Bildes mit dem zweiten MR-Bild, um dadurch die Bild-Positionen der Bezugsmarkierungen zu bestimmen. Anhand dieser Registrierung kann mit anderen Worten für jede Bezugsmarkierung die entsprechende Bild-Position bestimmt werden. Dazu wird jede Bild-Position einer Bezugsmarkierung in dem zweiten MR-Bild einer Position der Bezugsmarkierung in dem ersten Bild und damit der entsprechenden Bezugsmarkierung zugeordnet.

Indem die Anatomie aus dem rekonstruierten MR-Bild extrahiert wird, können das erste Bild und das zweite MR-Bild relativ einfach relativ zueinander registriert werden, um anhand dieser Registrierung die Bildpositionen der Bezugsmarkierungen zu bestimmen.

Im Rahmen der vorliegenden Erfindung wird auch eine Magnetresonanzanlage zur Korrektur von geometrischen Verzerrungen in einem MR-Bild bereitgestellt, welche neben einem Rahmen, in welchem Bezugsmarkierungen integriert sind, welche in vorbestimmten Soll-Abständen zueinander angeordnet sind, eine HF-Steuereinheit, eine Gradientensteuereinheit, eine Bildsequenzsteuerung und eine Recheneinheit umfasst. Der Rahmen ist ausgestaltet, um zumindest einen Teil eines lebenden Untersuchungsobjekts oder eines Patienten zu fixieren. Die Magnetresonanzanlage ist ausgestaltet, um mittels der HF-Steuereinheit, der Gradientensteuereinheit und der Bildsequenzsteuerung MR-Daten eines Volumenabschnitts zu erfassen, welcher zumindest einen Abschnitt des Teils des Untersuchungsobjekts umfasst und in welchem sich die Bezugsmarkierungen befinden. Mittels der Recheneinheit rekonstruiert die Magnetresonanzanlage das MR-Bild abhängig von den erfassten MR-Daten und bestimmt jeweils eine Bild-Position für jede Bezugsmarkierung innerhalb des MR-Bildes. Die Magnetresonanzanlage ist weiter ausgestaltet, um Abstände zwischen den Bild-Positionen zu bestimmen, um jeden dieser Abstände mit einem entsprechenden Soll-Abstand zu vergleichen, und um das MR-Bild abhängig von diesen Ergebnissen des Vergleichs zu korrigieren.

Die Vorteile der erfindungsgemäßen Magnetresonanzanlage entsprechen im Wesentlichen den Vorteilen des erfindungsgemäßen Verfahrens, welche vorab im Detail beschrieben worden sind, so dass hier auf eine Wiederholung verzichtet wird.

Bei dem Rahmen kann es sich um einen stereotaktischen Rahmen (z.B. Leksell-Rahmen oder Brown-Roberts-Wells-Rahmen) handeln, in welchem ein Kopf des Patienten fixierbar ist oder welcher an dem Kopf des Patienten fixierbar ist.

Des Weiteren beschreibt die vorliegende Erfindung ein Computerprogrammprodukt, insbesondere eine Software, welche man in einen Speicher einer programmierbaren Steuereinrichtung bzw. einer Recheneinheit einer Magnetresonanzanlage laden kann. Mit diesem Computerprogrammprodukt können alle oder verschiedene vorab beschriebene Ausführungsformen des erfindungsgemäßen Verfahrens ausgeführt werden, wenn das Computerprogrammprodukt in der Steuereinrichtung läuft. Dabei benötigt das Computerprogrammprodukt eventuell Programmmittel, z.B. Bibliotheken und Hilfsfunktionen, um die entsprechenden Ausführungsformen des Verfahrens zu realisieren. Mit anderen Worten soll mit dem auf das Computerprogrammprodukt gerichteten Anspruch insbesondere eine Software unter Schutz gestellt werden, mit welcher eine der oben beschriebenen Ausführungsformen des erfindungsgemäßen Verfahrens ausgeführt werden kann bzw. welche diese Ausführungsform ausführt. Dabei kann es sich bei der Software um einen Quellcode (z.B. C++), der noch compiliert und gebunden oder der nur interpretiert werden muss, oder um einen ausführbaren Softwarecode handeln, der zur Ausführung nur noch in die entsprechende Recheneinheit bzw. Steuereinrichtung zu laden ist.

Schließlich offenbart die vorliegende Erfindung einen elektronisch lesbaren Datenträger, z.B. eine DVD, ein Magnetband, eine Festplatte oder einen USB-Stick, auf welchem elektronisch lesbare Steuerinformationen, insbesondere Software (vgl. oben), gespeichert ist. Wenn diese Steuerinformationen (Software) von dem Datenträger gelesen und in eine Steuereinrichtung bzw. Recheneinheit einer Magnetresonanzanlage gespeichert werden, können alle erfindungsgemäßen Ausführungsformen des vorab beschriebenen Verfahrens durchgeführt werden.

Da sich die Bezugsmarkierungen vorteilhafterweise in jedem erfindungsgemäß erstellten MR-Bild befinden, kann die Bild-Position dieser Bezugsmarkierungen für das jeweilige MR-Bild zur Korrektur auch geringer geometrischer Ungenauigkeiten eingesetzt werden. Daher ermöglicht die vorliegende Erfindung quasi eine sogenannte All-in-One-Lösung zur Korrektur geometrischer Verzerrungen, ohne dass eine Dritthersteller-Software zur Korrektur, z.B. auf Basis von geometrietreuen CT-Bildern, benötigt wird. Darüber hinaus ermöglicht die vorliegende Erfindung im Vergleich zum Stand der Technik eine exaktere patientenspezifische Therapieplanung.

Im Gegensatz zu einer bekannten Phantomkalibrierung erfolgt die erfindungsgemäße Korrektur anhand von Ergebnissen, welche jeweils individuell abhängig von den Zuständen (z.B. Abweichungen des Hauptmagnet- und Gradientenfeldes von den idealen Bedingungen) beim Erfassen der MR-Daten sind. Dadurch können beispielsweise auch patientenspezifische Ursachen der Verzerrung bei der erfindungsgemäßen Korrektur berücksichtigt werden.

Die vorliegende Erfindung ermöglicht somit die MR-Bildgebung auch für die intrakranielle stereotaktische Radiochirurgie und für die Radiotherapieplanung.

Im Folgenden wird die vorliegende Erfindung anhand erfindungsgemäßer Ausführungsformen mit Bezug zu den Figuren im Detail beschrieben.

Fig. 1 stellt eine erfindungsgemäße Magnetresonanzanlage dar.

In Fig. 2 ist erfindungsgemäß schematisch ein Leksell-Rahmen, in welchen der Kopf eines Patienten eingespannt ist, dargestellt.

In Fig. 3 ist ein MR-Bild eines in einen Leksell-Rahmen eingespannten Kopfes eines Patienten dargestellt.

In Fig. 4 ist der Flussplan eines erfindungsgemäßen Verfahrens zur Korrektur von geometrischen Verzerrungen in einem MR-Bild dargestellt.

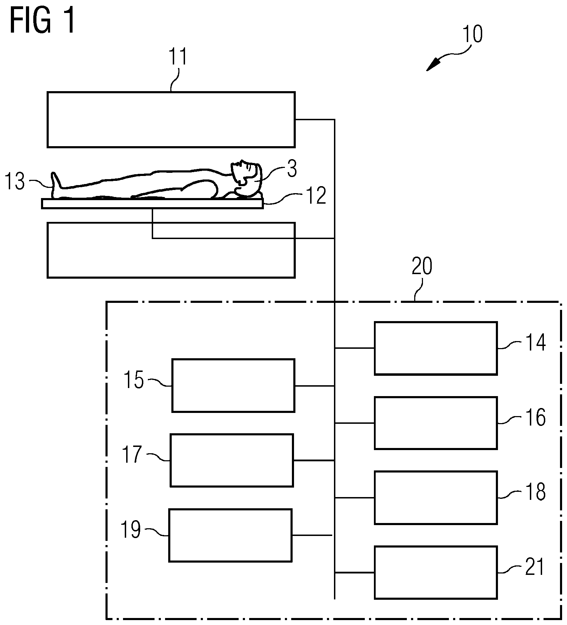

Mit Bezug zu Fig. 1 wird eine Magnetresonanzanlage 10 dargestellt, mit der, wie nachfolgend erläutert wird, erfindungsgemäß MR-Daten erfasst werden. Die Magnetresonanzanlage 10 weist einen Magneten 11 zur Erzeugung eines Polarisationsfelds B0 auf, wobei eine auf einer Liege 12 angeordnete Untersuchungsperson 13 in den Magneten 11 gefahren wird, um dort ortskodierte Magnetresonanzsignale bzw. MR-Daten aus der Untersuchungsperson 13 aufzunehmen. Die zur Signalaufnahme verwendeten Spulen wie eine Ganzkörperspule oder Lokalspulen sind aus Übersichtlichkeitsgründen nicht dargestellt. Durch Einstrahlen von Hochfrequenzpulsen und Schalten von Magnetfeldgradienten kann die durch das Polarisationsfeld B0 erzeugte Magnetisierung aus der Gleichgewichtslage ausgelenkt und ortskodiert werden, und die sich ergebende Magnetisierung wird von den Empfangsspulen detektiert. Wie durch Einstrahlen der HF-Pulse und durch Schalten von Magnetfeldgradienten in verschiedenen Kombinationen und Reihenfolgen MR-Bilder erzeugt werden können, ist dem Fachmann grundsätzlich bekannt und wird hier nicht näher erläutert.

Die Magnetresonanzanlage 10 weist weiterhin eine Steuereinheit 20 auf, die zur Steuerung der Magnetresonanzanlage 10 verwendet werden kann. Die Steuerung 20 weist eine Gradientensteuereinheit 15 zur Steuerung und Schaltung der notwendigen Magnetfeldgradienten auf. Eine HF-Steuereinheit 14 ist für die Steuerung und Generierung der HF-Pulse zur Auslenkung der Magnetisierung vorgesehen. Eine Bildsequenzsteuerung 16 steuert die Abfolge der Magnetfeldgradienten und HF-Pulse und damit indirekt die Gradientensteuereinheit 15 und die HF-Steuereinheit 14. Über eine Eingabeeinheit 17 kann eine Bedienperson die Magnetresonanzanlage 10 steuern, und auf einer Anzeigeeinheit 18 können MR-Bilder und sonstige zur Steuerung notwendigen Informationen angezeigt werden. Eine Recheneinheit 19 mit mindestens einer Prozessoreinheit (nicht gezeigt) ist vorgesehen zur Steuerung der verschiedenen Einheiten in der Steuereinheit 20 und zur Durchführung von Rechenoperationen. Weiterhin ist eine Speichereinheit 21 vorgesehen, in der beispielsweise Programmmodule bzw. Programme abgespeichert sein können, die, wenn sie von der Recheneinheit 19 bzw. ihrer Prozessoreinheit ausgeführt werden, den Ablauf der Magnetresonanzanlage 10 steuern können. Die Recheneinheit 19 ist ausgebildet, um aus den erfassten MR-Signalen die MR-Bilder zu berechnen.

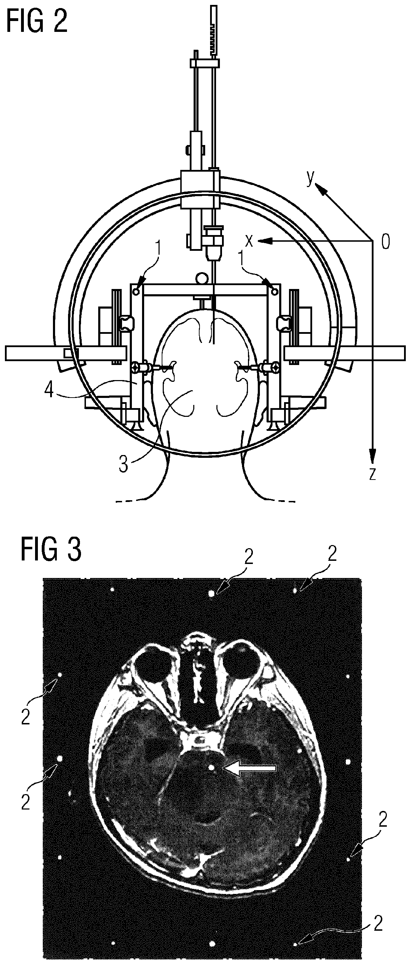

In Fig. 2 ist ein Leksell-Rahmen 4 dargestellt, in welchen der Kopf 3 eines Patienten 13 eingespannt ist. In diesem stereotaktischen Leksell-Rahmen 4, welcher Bestandteil der Magnetresonanzanlage 10 ist, sind an exakt vorbestimmten Positionen Bezugsmarkierungen 1 integriert. Dabei sei erwähnt, dass nur der rechteckige Teil des Rahmens 4, welcher am Kopf 3 des Patienten 13 fixiert ist, in die Magnetresonanzanlage 10 geschoben wird.

In Fig. 3 ist ein MR-Bild dargestellt, welches anhand von MR-Daten rekonstruiert wurde, welche von einem Volumenabschnitt erfasst wurden, welcher den in Fig. 2 dargestellten Leksell-Rahmen 4 und den darin eingespannten Kopf 3 umfasst. Neben der Anatomie des Kopfes 3 sind in diesem MR-Bild von dem Leksell-Rahmen 3 nur die Bezugsmarkierungen 1 in Form entsprechender Bild-Positionen 2 sichtbar.

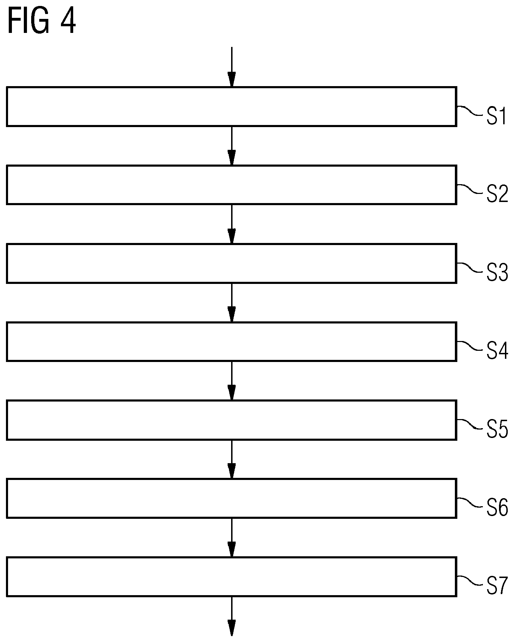

Die Positionen der einzelnen Bildmarkierungen 1 innerhalb des Leksell-Rahmens 4 und damit die Soll-Abstände zwischen diesen Bildmarkierungen 1 sind konstant und bekannt. Indem in dem MR-Bild jede Bild-Position 2 der zugehörigen Bezugsmarkierung zugeordnet wird, können die Ist-Abstände dieser Bild-Positionen 2 bestimmt und mit den zugehörigen Soll-Abständen verglichen werden. Anhand dieses Vergleichs können die Ausmaße einer geometrischen Verzerrung bestimmt werden, um dadurch beispielsweise ein Deformationsfeld zu bestimmen. Mit Hilfe dieses Deformationsfeldes kann dann das rekonstruierte MR-Bild und somit die geometrische Verzerrung korrigiert werden. In Fig. 4 ist der Flussplan eines erfindungsgemäßen Verfahrens dargestellt.

Im ersten Schritt S1 werden die MR-Daten eines Kopfes eines Patienten erfasst, welcher in einem Leksell-Rahmen 4 eingespannt ist. Anhand dieser MR-Daten wird im zweiten Schritt S2 ein MR-Bild rekonstruiert. Innerhalb dieses MR-Bildes wird für jede Bezugsmarkierung im Schritt S3 die zugehörige Bild-Position innerhalb des MR-Bildes bestimmt. Im Schritt S4 werden die Abstände zwischen diesen Bild-Positionen bestimmt, um im Schritt S5 die im Schritt S4 bestimmten Abstände mit Soll-Abständen zwischen bestimmten Bezugsmarkierungen zu vergleichen.

Anhand der Ergebnisse dieses Vergleichs wird im Schritt S6 ein Deformationsfeld erstellt. Dieses Deformationsfeld definiert quasi für jeden Bildpunkt des rekonstruierten MR-Bildes einen Verschiebungsvektor. Im Schritt S7 wird das rekonstruierte MR-Bild mit Hilfe des Deformationsfeldes korrigiert. Dazu wird quasi jeder Bildpunkt des rekonstruierten MR-Bildes entsprechend der durch das Deformationsfeld definierten Verschiebungsvektoren verschoben. Dadurch ergibt sich ein korrigiertes MR-Bild, in welchem geometrische Verzerrungen, welche sich aufgrund der individuell beim Erfassen der MR-Daten vorliegenden Abweichungen (insbesondere des Hauptmagnet- und Gradientenfeldes) von den idealen Bedingungen ergeben, korrigiert sind.

## Patentansprüche

1. Verfahren zur Korrektur von geometrischen Verzerrungen in einem MR-Bild,
wobei das Verfahren folgende Schritte umfasst:
Erfassen von MR-Daten eines Volumenabschnitts einer Untersuchungsperson (13) mittels einer Magnetresonanzanlage (10),
wobei sich in dem Volumenabschnitt mehrere Bezugsmarkierungen (1) befinden, welche in vorbestimmten Soll-Abständen zueinander angeordnet sind,
Rekonstruieren des MR-Bildes abhängig von den erfassten MR-Daten,
Bestimmen einer jeweiligen Bild-Position (2) jeder der Bezugsmarkierungen (1) innerhalb des MR-Bildes,
Bestimmen von Abständen zwischen den Bild-Positionen (2),
Vergleichen der Abstände jeweils mit einem entsprechenden der Soll-Abstände, und
Korrigieren des MR-Bildes abhängig von Ergebnissen des Vergleichs-Schritts.

2. Verfahren nach Anspruch 1,
**dadurch gekennzeichnet,**
**dass** abhängig von den Ergebnissen des Vergleichs-Schritts ein Deformationsfeld erstellt wird, und
**dass** anhand dieses Deformationsfeldes das MR-Bild korrigiert wird.

3. Verfahren nach Anspruch 1 oder 2,
**dadurch gekennzeichnet,**
**dass** die Bezugsmarkierungen (1) in einem Rahmen (4) integriert sind, mit welchem ein Teil (3) der Untersuchungsperson (13) fixiert wird, und
**dass** der Volumenabschnitt zumindest einen Abschnitt des Teils (3) umfasst.

4. Verfahren nach Anspruch 3,
**dadurch gekennzeichnet,**
**dass** der Rahmen ein stereotaktischer Rahmen ist, und
**dass** der Teil der Untersuchungsperson (13) der Kopf der Untersuchungsperson (13) ist.

5. Verfahren nach einem der vorhergehenden Ansprüche,
**dadurch gekennzeichnet,**
**dass** die Bezugsmarkierungen (1) CuSO₄ dotiertes Wasser umfassen, um ein eindeutiges Signal in dem MR-Bild zu erzeugen.

6. Verfahren nach einem der vorhergehenden Ansprüche,
**dadurch gekennzeichnet,**
**dass** das Bestimmen der jeweiligen Bild-Position (2) mittels einer Segmentierung, Mustererkennung und/oder Deep Learning erfolgt.

7. Verfahren nach einem der vorhergehenden Ansprüche,
**dadurch gekennzeichnet,**
**dass** das Bestimmen der jeweiligen Bild-Position (2) folgende Unterschritte aufweist:
Erstellen eines ersten Bildes, welches im Wesentlichen nur die Bezugsmarkierungen (1) darstellt,
Extrahieren einer Anatomie aus dem abhängig von den erfassten MR-Daten rekonstruierten MR-Bild, um ein zweites MR-Bild zu erstellen, und
Registrieren des ersten Bildes mit dem zweiten MR-Bild, um zu bestimmen, welche Bild-Position (2) einer Bezugsmarkierung (1) welcher Position der Bezugsmarkierung (1) in dem ersten Bild und damit welcher der Bezugsmarkierungen (1) zugeordnet ist.

8. Magnetresonanzanlage (10) zur Korrektur von geometrischen Verzerrungen in einem MR-Bild, wobei die Magnetresonanzanlage (10) eine HF-Steuereinheit (14), eine Gradientensteuereinheit (15), eine Bildsequenzsteuerung (16), eine Recheneinheit (19) und einen Rahmen (4) umfasst, in welchem Bezugsmarkierungen (1) integriert sind, welche in vorbestimmten Soll-Abständen zueinander abgeordnet sind,
wobei der Rahmen (4) ausgestaltet ist, um zumindest einen Teil (3) einer Untersuchungsperson (13) bezüglich der Magnetresonanzanlage zu fixieren,
wobei die Magnetresonanzanlage (10) ausgestaltet ist,
um MR-Daten eines Volumenabschnitts zu erfassen, welcher zumindest einen Abschnitt des Teils (3) der Untersuchungsperson (13) umfasst und in welchem sich die Bezugsmarkierungen (1) befinden,
um das MR-Bild abhängig von den erfassten MR-Daten zu rekonstruieren,
um eine jeweilige Bild-Position (2) jeder der Bezugsmarkierungen (1) innerhalb des MR-Bildes zu bestimmen,
um Abstände zwischen den Bild-Positionen (2) zu bestimmen,
um die Abstände jeweils mit einem entsprechenden der Soll-Abstände zu vergleichen, und
um das MR-Bild abhängig von Ergebnissen des Vergleichs zu korrigieren.

9. Magnetresonanzanlage nach Anspruch 8,
**dadurch gekennzeichnet,**
**dass** der Rahmen ein stereotaktischer Rahmen (4) ist, und dass der Teil der Untersuchungsperson (13) der Kopf (3) der Untersuchungsperson (13) ist.

10. Magnetresonanzanlage nach Anspruch 8 oder 9,
**dadurch gekennzeichnet,**
**dass** die Magnetresonanzanlage (10) zur Durchführung des Verfahrens nach einem der Ansprüche 1-7 ausgestaltet ist.

11. Computerprogrammprodukt, welches ein Programm umfasst und direkt in einen Speicher einer programmierbaren Steuereinrichtung (20) einer Magnetresonanzanlage (10) ladbar ist, mit Programm-Mitteln, um alle Schritte des Verfahrens nach einem der Ansprüche 1-7 auszuführen, wenn das Programm in der Steuereinrichtung (20) der Magnetresonanzanlage (10) ausgeführt wird.

12. Elektronisch lesbarer Datenträger mit darauf gespeicherten elektronisch lesbaren Steuerinformationen, welche derart ausgestaltet sind, dass sie bei Verwendung des Datenträgers (21) in einer Steuereinrichtung (20) einer Magnetresonanzanlage (10) das Verfahren nach einem der Ansprüche 1-7 durchführen.
